# EUROPEAN PATENT APPLICATION

(11) **EP 4 641 626 A1**
(43) Date of publication of application: **29.10.2025**
(21) Application number: 24199243.7
(22) Date of filing: 09.09.2024
(51) Int. Cl.: H01L 21/67

(54) **SUBSTRATE PROCESSING APPARATUS, METHOD OF PROCESSING SUBSTRATE, METHOD OF MANUFACTURING SEMICONDUCTOR DEVICE, AND GAS RECTIFIER**

(30) Priority: 25.04.2024 JP 2024071652
(71) Applicant: Kokusai Electric Corporation, Tokyo 101-0045 (JP)
(72) Inventor: HORII, Akira, Toyama-shi, Toyama, 9392393 (JP); TANIGUCHI, Daiki, Toyama-shi, Toyama, 9392393 (JP)
(74) Representative: Bardehle Pagenberg Partnerschaft mbB Patentanwälte Rechtsanwälte

(57) **Abstract**

There is provided a configuration that includes at least one port that is provided in a process container in which a substrate is accommodated and heat-treated, the port providing an optical path that penetrates an interior of the process container and an exterior of the process container; an optical window that is mounted to the port and transmits light while maintaining the port airtight; a purge gas supplier that is disposed inside the process container and provides a purge gas to an inner surface of the optical window; and a partition that guides the purge gas from the purge gas supplier to the optical window.

## Description

### CROSS-REFERENCE TO RELATED APPLICATION

This application is based upon and claims the benefit of priority from Japanese Patent Application No. 2024-071652, filed on April 25, 2024, the entire contents of which are incorporated herein by reference.

### TECHNICAL FIELD

The present disclosure relates to a substrate processing apparatus, a method of processing a substrate, a method of manufacturing a semiconductor device, and a gas rectifier.

### BACKGROUND

In a method of manufacturing a semiconductor device, a vertical substrate processing apparatus may be used as an apparatus for forming an oxide film or a metal film on a substrate (hereinafter referred to as a wafer). When a predetermined film is formed on the wafer, a process chamber is heated to a predetermined temperature while supplying a process gas into the process chamber. In order to maintain the process chamber at the predetermined temperature, the substrate processing apparatus is provided with a temperature sensor, such as a radiation thermometer, for detecting the internal temperature of the process chamber.

When the radiation thermometer is used, the internal temperature of the process chamber is measured based on radiation light from the interior of the process chamber that is incident through an optical window.

However, when a temperature is measured using the radiation thermometer, the optical window is exposed inside the process chamber, and therefore contaminants from the process gas, particles, and the like may accumulate on the optical window, and contamination on the optical window may make it difficult to perform highly reproducible temperature measurements.

### SUMMARY

Some embodiments of the present disclosure provide a technique capable of stable temperature measurements.
According to one embodiment of the present disclosure, a substrate processing apparatus includes: at least one port provided in a process container in which a substrate is accommodated and heat-treated, the at least one port providing an optical path that penetrates an interior of the process container and an exterior of the process container; an optical window that is mounted to the at least one port and transmits light while maintaining the port airtight; a purge gas supplier that is disposed inside the process container and provides a purge gas to an inner surface of the optical window; and a partition that guides the purge gas from the purge gas supplier to the optical window.

### BRIEF DESCRIPTION OF DRAWINGS

The accompanying drawings, which are incorporated in and constitute a part of the specification, illustrate embodiments of the present disclosure.
FIG. 1 is a longitudinal sectional view showing an example of a process furnace according to an embodiment of the present disclosure.
FIG. 2 is a plane cross-sectional view showing an upper surface portion of a manifold in the process furnace according to the embodiment of the present disclosure.
FIG. 3 is an enlarged longitudinal sectional view showing a view port and its vicinity according to an embodiment of the present disclosure.
FIG. 4 is a perspective view showing a heat-insulating ring stacked body according to an embodiment of the present disclosure.
FIG. 5A is a perspective view of a gas rectifier.
FIG. 5B is a bottom view of the gas rectifier.
FIG. 6 is a flow diagram for explaining a method of processing a substrate according to an embodiment of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

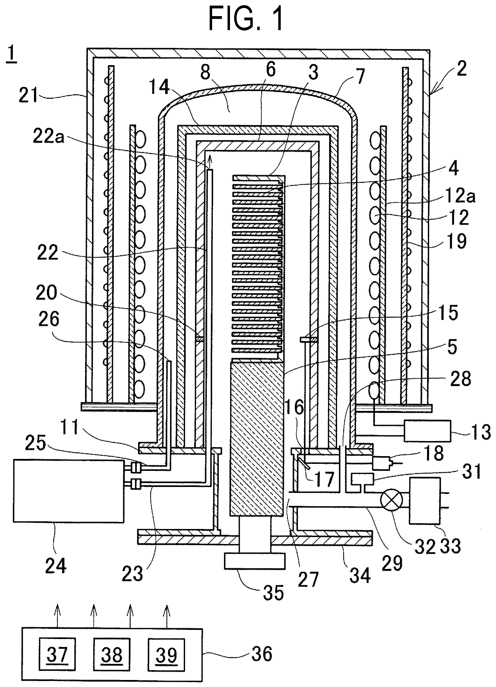

One embodiment of the present disclosure will now be described mainly with reference to FIGS. 1 to 6. The drawings used in the following description are all schematic, and the dimensional relationship, ratios, and the like of various elements shown in the drawings do not always match the actual ones. Further, the dimensional relationship, ratios, and the like of various elements between plural figures do not always match each other.

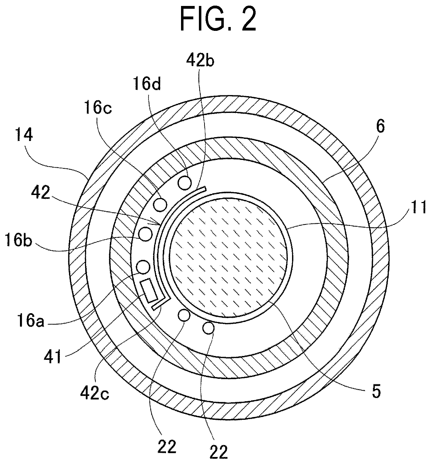

First, an embodiment of the present disclosure will be described with reference to FIG. 1. FIG. 1 shows a longitudinal sectional view of a process furnace 2 in a substrate processing apparatus 1 according to this embodiment. Note that FIGS. 2 to 5B are configured in the same manner as the substrate processing apparatus 1 shown in FIG. 1, elements that are substantially the same as those shown in FIG. 1 are denoted by the same reference numerals, and explanation thereof will not be repeated.

The substrate processing apparatus 1 according to this embodiment is configured as an apparatus that performs an annealing process on a plurality of SiC (silicon carbide) substrates aligned in the vertical direction, a so-called batch-type vertical SiC annealing apparatus. By configuring it as a batch-type processing apparatus, it becomes possible to process many substrates at a time, thereby improving productivity.

The substrate processing apparatus 1 has a process furnace 2, and a boat 3 as a substrate holder is configured to be insertable/detachable into/from the process furnace 2. The boat 3 is made of a heat resistant material such as carbon graphite or SiC. The boat 3 is configured to hold a plurality of wafers 4, which are substrates and are made of SiC or the like, stacked vertically in a horizontal posture with their centers aligned with each other. Further, a boat heat-insulator 5 made of a heat resistant material such as graphite (carbon graphite), SiC, or quartz is disposed at the bottom of the boat 3. The boat heat-insulator 5 is configured to support the boat 3 from below to make it difficult for heat from an induction target 6, which will be described later, to be transmitted to the lower side of the process furnace 2. The boat 3 charged with the plurality of wafers 4 is loaded into the process furnace 2, whereby heat treatment is performed. When the boat 3 is loaded into the process furnace 2, the boat heat-insulator 5 is disposed in the vicinity of an opening of a reaction tube 7.

Next, the configuration of the process furnace 2 provided in the substrate processing apparatus 1 will be described.

As shown in FIG. 1, the process furnace 2 includes the reaction tube 7 which is made of a heat resistant material such as quartz or SiC and is formed in a cylindrical shape with its upper end closed and its lower end opened. A process chamber 8 is formed in a hollow cylindrical portion of the reaction tube 7. The process chamber 8 is configured to accommodate the above-described boat 3 which holds the wafers 4.

A manifold 11 is disposed below the reaction tube 7 to be concentric with the reaction tube 7. The manifold 11 is made of, for example, stainless steel, and is formed in a cylindrical shape extending vertically. The manifold 11 is provided to support the reaction tube 7 from below. An O-ring 9 as a seal is provided between the manifold 11 and the reaction tube 7. The manifold 11 is supported by a holder (not shown) so that the reaction tube 7 is installed vertically. The reaction tube 7 and the manifold 11 form a process container.

The process furnace 2 includes an induction target 6 as a heat-generator heated by induction heating, and an induction coil 12 as an induction heater, i.e., a magnetic field generator. The induction target 6 is made of a conductive heat resistant material such as dense carbon, is formed in a cylindrical shape, and is disposed inside the reaction tube 7 so as to surround the boat 3, i.e., to surround an accommodation region of the wafers 4. The induction target 6 is formed in a cylindrical shape with its upper end closed and its lower end opened and exhibits a certain degree of airtightness or the ability to prevent the intrusion of particles when placed on the manifold 11. The induction coil 12 is supported by a coil support 12a made of an insulating heat resistant material and is provided to surround an outer periphery of the reaction tube 7. The induction coil 12 is configured to be supplied with AC power of, for example, 10 to 450kHz and 10 to 200kW from an AC power source 13. An induced current, i.e., an eddy current, flows through the induction target 6 due to an alternating magnetic field generated by flowing an alternating current through the induction coil 12, whereby the induction target 6 generates heat due to Joule heat. As the induction target 6 generates heat, the wafers 4 held in the boat 3 are heated to a predetermined processing temperature, for example, 1500 degrees C to 2000 degrees C, by the radiant heat emitted from the induction target 6. Further, in order to prevent thermal damage, it is preferable to maintain the temperature of the constituent members, such as the manifold 11, below the process furnace 2 at a temperature of, for example, 200 degrees C or lower.

A heat insulator 14, which is made of, for example, carbon felt having excellent heat resistance, is provided between the reaction tube 7 and the induction target 6. The heat insulator 14 is formed in a cylindrical shape with its upper end closed and its lower end opened. By providing the heat insulator 14, it is possible to suppress the transfer of heat from the induction target 6 to the reaction tube 7 or the outside of the reaction tube 7.

In addition, a substantially annular or substantially cylindrical support 20 provided inside the reaction tube 7 along an inner peripheral surface of the induction target 6 is provided at a predetermined height on the inner surface of the induction target 6. The support 20 is concentric with the induction target 6, and a temperature measurement chip 15 protruding toward the central side of the process chamber 8 is supported on the inner surface of the support 20.

A view port 16, which is made of, for example, a transparent quartz material, is formed at a position facing the temperature measurement chip 15 on the upper surface of the manifold 11 (the surface exposed inside the reaction tube 7, i.e., the inner surface). Further, in a space below the process chamber 8, a radiation light reflection mirror 17 and a radiation thermometer 18, which is a temperature detection means, are provided at a position facing the temperature measurement chip 15 through the view port 16. The radiation thermometer 18 can measure the temperature of the temperature measurement chip 15 by receiving radiation light such as infrared light emitted from the temperature measurement chip 15 as a target and reflected by the radiation light reflection mirror 17.

In addition, the temperature measurement chip 15 and the induction target 6 are made of the same material, and the temperature measurement chip 15 is provided close to the induction target 6. Therefore, the temperature measurement chip 15 is heated in the same manner as the induction target 6 to make the temperature of the temperature measurement chip 15 equal to the temperature of the induction target 6. Therefore, by measuring the temperature of the temperature measurement chip 15, the temperature of the induction target 6 can be accurately measured.

The radiation thermometer 18 is electrically connected to a temperature controller (not shown). The temperature controller controls the processing temperature of the wafers 4 to a desired temperature by adjusting a degree of current flow from the AC power source 13 to the induction coil 12 based on the temperature information detected by the radiation thermometer 18. A heater according to this embodiment mainly includes the induction target 6, the induction coil 12, the AC power source 13, the temperature measurement chip 15, the view port 16, and the radiation thermometer 18.

In addition, one each of the temperature measurement chip 15, the view port 16, the radiation thermometer 18, and the support 20 is shown in FIG. 1, but a plurality of view ports 16, for example, four view ports, are disposed along an imaginary circle concentric with the axis of the reaction tube 7. The temperature measurement chip 15, the radiation thermometer 18, and the support 20 are also arranged corresponding to each view port 16, and each temperature measurement chip 15 and each support 20 are arranged at different heights.

In addition, an outer heat-insulating wall 19 having, for example, a water-cooled structure, which suppresses the transfer of heat from the interior of the process chamber 8 to the outside, is provided outside the induction coil 12 so as to surround the process chamber 8. Further, a magnetic shield 21, which prevents the magnetic field generated by the induction coil 12 from leaking to the outside, is provided outside the outer heat-insulating wall 19. The outer heat insulating wall 19 and the magnetic shield 21 may be configured as an integral structure.

A first gas nozzle 22 having a first gas supply port 22a, etc. is disposed in the process furnace 2. The first gas nozzle 22 is disposed inside the heat-generator 6 and vertically between the accommodation region of the wafers 4 and the induction target 6. The first gas nozzle 22 is made of a heat resistant material such as carbon graphite. The first gas supply port 22a may be provided at the upper end (tip) or side of the first gas nozzle 22. The downstream end of a first gas supply pipe 23 is connected to the upstream side of the first gas nozzle 22. The first gas supply pipe 23 is provided so as to penetrate the manifold 11. A gas supply unit 24 is connected to the upstream end of the first gas supply pipe 23. Only one first gas nozzle 22 is shown in FIG. 1, but two gas nozzles are provided between the accommodation region of the wafers 4 and the induction target 6.

A second gas supply pipe 25 is disposed outside the induction target 6 and vertically between the heat insulator 14 and the reaction tube 7. A second gas supply port 26 is provided at the downstream end of the second gas supply pipe 25. The second gas supply pipe 25 is provided so as to penetrate the manifold 11. The gas supply unit 24 is connected to the upstream end of the second gas supply pipe 25.

A first exhaust port 27 is provided on the side of the boat heat-insulator 5, i.e., the lower side of the accommodation region of the wafers 4 and in the side wall of the manifold 11 facing the first gas supply port 22a. In addition, a second exhaust port 28 is provided between the heat insulator 14 and the reaction tube 7 and on the constituent wall of the manifold 11 on which the reaction tube 7 is mounted. The upstream ends of a branched exhaust pipe 29 are connected to the first exhaust port 27 and the second exhaust port 28, respectively. The exhaust pipe 29 is provided with a pressure sensor 31 as a pressure detector, an APC (Auto Pressure Controller) valve 32 as a pressure regulator, and a vacuum pump 33 as a vacuum exhaust device, in that order from the upstream side. The pressure sensor 31, the APC valve 32, and the vacuum pump 33 are electrically connected to a pressure controller (not shown). The pressure controller controls the opening degree of the APC valve 32 in a feedback manner based on the pressure information measured by the pressure sensor 31, thereby controlling the internal pressure of the process chamber 8 to a predetermined pressure at a predetermined timing.

By providing the first exhaust port 27 as described above, a gas supplied from the first gas supply port 22a into the process chamber 8, i.e., a process gas, flows downward inside the process chamber 8, i.e., inside the induction target 6, through a region where the boat heat-insulator 5 is provided, and is exhausted through the first exhaust port 27. At this time, the entire wafers 4 are efficiently and uniformly exposed to the gas.

Further, by providing the second exhaust port 28 as described above, an inert gas such as nitrogen supplied from the second gas supply port 26 into the process chamber 8 acts as a purge gas, flows between the reaction tube 7 and the heat insulator 14, and is exhausted through the second exhaust port 28. This allows contaminants evaporated from the induction target 6 and the heat insulator 14 to be quickly discharged before they diffuse into the induction target 6, and also prevents the process gas from entering between the induction target 6 and the reaction tube 7.

Further, the boat 3 is capable of being loaded into the process chamber 8, i.e., boat loading, and being unloaded from the process chamber 8, i.e., boat unloading, by a lifting mechanism (not shown). By loading the boat 3 into the process chamber 8, the opening, i.e., the furnace opening, of the process furnace 2, is configured to be closed airtight by a seal cap 34 via a seal such as an O-ring. Furthermore, a boat rotation mechanism 35 supporting the boat heat-insulator 5 penetrates the center of the seal cap 34, so that the boat 3 can be rotated by the boat rotation mechanism 35.

A controller 36 controls various parts of the substrate processing apparatus 1 and has a central processing unit (CPU) 37, a main memory 38, and an auxiliary memory 39. The auxiliary memory 39 stores recipe information including a series of operations for causing the substrate processing apparatus 1 to perform an annealing process and the like, and a program executed by the CPU 37 to actually control the substrate processing apparatus 1 based on the recipe information. The auxiliary memory 39 may include a recording medium such as an optical disc. Note that a gas rectifier 42 and a heat-insulating ring stacked body 43, which will be described later, are omitted from FIG. 1.

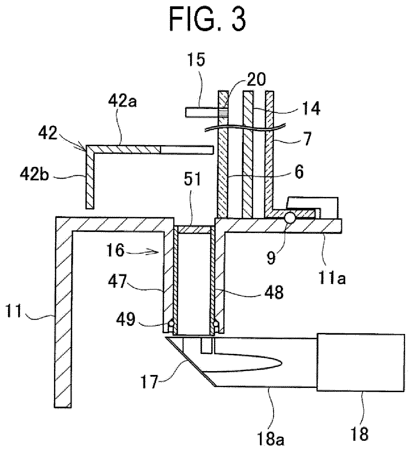

Next, the opening of the reaction tube 7 and the configuration of its surroundings will be described with reference to FIGS. 2 and 3. FIG. 2 is a cross-sectional view of the process furnace 2 near and above the upper surface of the manifold 11.

The upper surface of the manifold 11 is provided with four view ports 16 (16a, 16b, 16c, and 16d) disposed in sequence along an imaginary circle concentric with the axis of the reaction tube 7, a purge gas supplier 41 disposed to supply an inert gas as a purge gas (e.g., argon (Ar) or nitrogen (N₂)) toward the view ports 16a to 16d, and a partially-opened annular gas rectifier 42 disposed above the upper surface of the manifold 11, inside the induction target 6, i.e., inside the reaction tube 7.

The purge gas supplier 41 is disposed to be adjacent to the view port 16a on the upper surface of the manifold 11, is connected to the gas supply unit 24 so that a fluid can flow therethrough, and ejects the purge gas, which is supplied from the gas supply unit 24, in the circumferential direction of the imaginary circle. Further, the purge gas supplier 41 may be connected to the second gas supply pipe 25 and may extract and eject a portion of the purge gas supplied to the second gas supply pipe 25.

The view ports 16a to 16d and the purge gas supplier 41 are respectively disposed along the circular opening of the reaction tube 7 and along the inner periphery of the induction target 6 on the inner peripheral side of the reaction tube 7. The gas rectifier 42 has a plate 42a disposed in parallel to the upper surface of the manifold 11 so as to partially cover the upper sides of the view ports 16a to 16d, and a partition 42b as a guide that extends upward in parallel to the axis of the reaction tube 7 on the inner periphery above the view ports 16a to16d. The partition 42b is made of a heat resistant material, such as graphite, and is formed as a plate in an arc shape on the inner periphery of the view ports 16a to 16d and the purge gas supplier 41 and along the arrangement of the view ports 16a to 16d. In addition, one end side of the partition 42b, i.e., the end portion of the purge gas supplier 41 side, is formed with a bent portion 42c that is bent at a right angle or substantially a right angle toward the outside in the radial direction, and the other end portion of the partition 42b, i.e., the end portion of the view port 16d side, extends further toward the other end side than the view port 16d. The bent portion 42c prevents the purge gas injected from the purge gas supplier 41 from drawing in a surrounding unclean gas and flowing together with it into the view ports 16a to 16d.

The plate 42a is formed, for example, by forming a flat graphite plate into a partially-opened ring shape, and two first gas nozzles 22 are disposed in a ring-open portion 55a which is an opened portion of the plate 42a. In other words, the ring-open portion 55a is configured to be able to avoid contact between the plate 42a and the base of the first gas nozzles 22 and 22 disposed in the vertical direction. In addition, the plate 42a has notches 53a to 53d directly above the view ports 16a to 16d.

The upper end of the bent portion 42c is connected substantially at a right angle to the end portion of the plate 42a. In addition, the upper end of the partition 42b is connected substantially at a right angle to the end of the inner circumference of the plate 42a. In addition, the partition 42b and the bent portion 42c are not limited to being connected to the plate 42a by integral formation, but may be formed separately and disposed so that the upper ends of the partition 42b and the bent portion 42c are in contact with or close to the end portion of the plate 42a. In addition, since the gas rectifier 42 blocks radiation from the induction target 6 that has become hot, it is possible to suppress the upper surface 11a of the manifold 11 from being heated by radiation and to suppress unwanted light from entering the view port 16.

As described above, a space around the purge gas supplier 41 and the view ports 16a to 16d is blocked in the radial direction by the partition 42b of the gas rectifier 42 and the induction target 6, blocked on one side in the circumferential direction by the bent portion 42c, and blocked above by the plate 42a except for the notches 53a to 53d. Without the gas rectifier 42, the purge gas from the purge gas supplier 41 would easily flow down into the annular space between the boat heat-insulator 5 and the manifold 11 before reaching the view port 16d and would be discharged through the first exhaust port 27. By providing the gas rectifier 42, a flow path is formed in which the purge gas from the purge gas supplier 41 passes above the view ports 16a to 16d before being discharged.

As shown in FIG. 3, the view port 16 is composed of a port 47 formed to extend in the longitudinal direction (tube axis direction) of the reaction tube 7 (process container), a cylindrical portion 48 inserted into the port 47, a seal 49 that seals airtight between the port 47 and the cylindrical portion 48, and an optical window 51 held by the cylindrical portion 48. Note that only one view port 16 and its constituent elements are shown in FIG. 3, but a plurality of view ports 16 and their constituent elements, for example, four view ports 16 and their constituent elements, are provided.

The port 47 is a cylindrical member whose upper end opens upward on the upper surface 11a of the manifold 11 (i.e., the inner surface 11a exposed in the reaction tube 7), i.e., a surface perpendicular to the tube axis on the opening side of the reaction tube 7, and the inside and outside of the reaction tube 7 are communicated to each other via the port 47.

The cylindrical portion 48 is a cylindrical member made of, for example, SUS, and is mounted inside the port 47. In addition, the seal 49, which is, for example, a heat resistant adhesive or heat resistant resin, is provided between the outer surface of the lower end portion of the cylindrical portion 48 and the inner surface of the port 47 and seals airtight between the inner periphery of the port 47 and an outer periphery of the cylindrical portion 48. Furthermore, the disc-shaped optical window 51 made of, for example, transparent sapphire is brazed airtight and fixed to the inner surface of the upper end of the cylindrical portion 48. Therefore, the internal atmosphere and the external atmosphere of the view port 16 are isolated from each other by the optical window 51 and the seal 49. Further, the upper surface of the optical window 51 is substantially flush with the inner surface 11a of the manifold 11 or slightly lower than the inner surface 11a.

A lens barrel 18a having the radiation light reflecting mirror 17 is provided at the lower end of the port 47, and the radiation thermometer 18 is provided on the reflection optical axis of the radiation light reflecting mirror 17. That is, the port 47 provides an optical path parallel to the tube axis for guiding the radiation light to the radiation thermometer 18. Therefore, the optical path of the radiation light penetrates the interior and exterior of the process chamber 8 and extends in the longitudinal direction of the reaction tube 7 inside the induction target 6, so that the radiation thermometer 18 can measure the temperature of the temperature measurement chip 15. The optical path of the radiation light passes through the notches 53a to 53d of the gas rectifier 42 to reach the temperature measurement chip 15.

When the purge gas is ejected from the purge gas supplier 41, the purge gas is supplied toward the upper surface (the surface exposed inside the reaction tube 7, i.e., the inner surface) of the view port 16 (the view port 16a). The partition 42b and the induction target 6 block the radial direction (horizontal direction), the bent portion 42c blocks one side (rear) in the circumferential direction, and the plate 42a blocks the upper side, so that the purge gas is guided to the partition 42b and the induction target 6 and flows from the view port 16a toward the view port 16d. The purge gas that passes through the view port 16d continues to flow in the circumferential direction along the induction target 6 and gradually flows down into the manifold 11.

By supplying the purge gas, a diffusion barrier for the process gas is formed and particles can be blown away, making it possible to suppress contamination of the view port 16. In addition, since the purge gas flows over the upper surface of the view port 16, the temperature rise of the view port 16 can be suppressed, thereby preventing the view port 16 from being vacuum-destroyed by heat. In addition, since the optical window 51 is mounted so as to be substantially flush with the upper surface 11a (the inner surface 11a) of the manifold 11, the purge gas can be sprayed efficiently. Furthermore, since a flow path surrounded on the top, bottom, left and right by the manifold 11 is formed by the gas rectifier 42 having the partition 42b extending in substantially parallel to the optical path, the induction target 6, and the manifold 11, the purge gas is supplied to the view port 16d without being scattered, thereby further improving the effect of suppressing contamination of the view port 16 and the effect of suppressing the temperature rise.

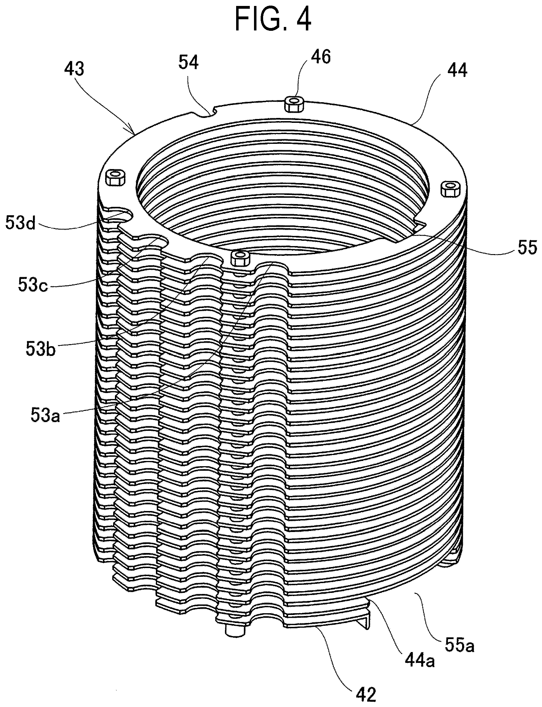

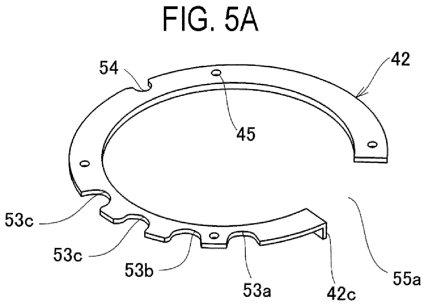

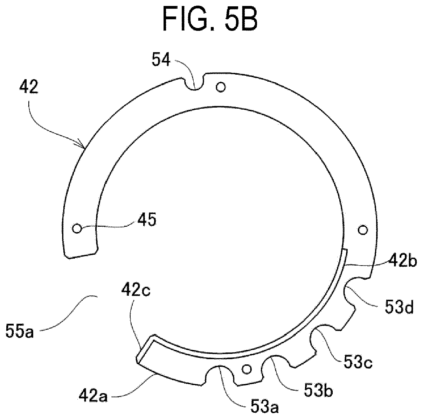

Next, the details of the heat-insulating ring stacked body 43 will be described with reference to FIGS. 4, 5A, and 5B. The heat-insulating ring stacked body 43 is configured as a heat-insulating assembly in which heat-insulating rings 44 are stacked in multiple stages, and is disposed between the boat heat-insulator 5 and the induction target 6. In this example, the heat-insulating ring stacked body 43 uses the gas rectifier 42 for the lowermost heat-insulating ring. The heat-insulating ring stacked body 43 is positioned and integrated by fasteners 46 such as bolts through holes 45 formed at a predetermined angular interval. In addition, the stacked heat-insulating rings 44 are disposed in the vicinity of the opening of the reaction tube 7 to improve the insulation between the interior and the exterior of the process chamber 8, thereby suppressing the temperature rise of the manifold 11. The heat-insulating ring stacked body 43 is made of heat resistant materials such as graphite, SiC, and quartz.

The plurality of heat-insulating rings 44 have basically the same shape and are annular plates with an opening in the center for inserting the boat heat-insulator 5. Each heat-insulating ring 44 has four holes 45 formed at a predetermined angular interval, notches 53a to 53d formed on the outer periphery, a notch 54 formed on the outer periphery apart from the notches 53a to 53d, and a rectangular notch 55 formed on the inner periphery.

Four fasteners 46 are, for example, a set of bolts and nuts, and are inserted into the holes 45 to fix the heat-insulating rings 44. A normal spacer for maintaining a constant distance between adjacent heat-insulating rings 44 may be inserted together with the heat-insulating rings 44. The fasteners 46 protrude from the upper and lower ends of the heat-insulating ring stacked body 43. When the heat-insulating ring stacked body 43 is mounted on the upper surface 11a of the manifold 11, the fasteners 46 function as feet. It is desirable that the center and orientation of the heat-insulating ring stacked body 43 be accurately positioned so that the notches 53a to 53d are located directly above the view ports 16a to 16d. When a recess that fits the fasteners 46 is provided on the upper surface 11a, the fasteners 46 function as positioning means.

The notch 54 is used to position a profile thermocouple during temperature calibration. The notch 55 is for avoiding contact between the heat-insulating ring 44 and the first gas nozzles 22 and 22 and is disposed in the same direction as the ring-open portion 55a. The notches 53a to 53d secure an optical path of the light thermally radiated from each temperature measurement chip 15 without being blocked by the heat-insulating ring 44.

In addition, among the heat-insulating rings constituting the heat-insulating ring stacked body 43, the second heat-insulating ring 44a from the bottom has the ring-open portion 55a similar to that of the gas rectifier 42, unlike the other insulating rings 44, etc. The ring-open portion 55a is disposed at a position opposite to the notch 55, and the base of the first gas nozzles 22 and 22 is disposed in the ring-open portion 55a. In this embodiment, the heat-insulating ring 44 at the height where the base of the first gas nozzles 22 and 22 is located is set as the heat-insulating ring 44a having the ring-open portion 55a, thereby avoiding contact between the heat-insulating ring 44 and the first gas nozzles 22 and 22. In addition, the first heat-insulating ring from the bottom of the heat-insulating ring stacked body 43 may be the same as the second heat-insulating ring 44a from the bottom, and only the partition 42b of the gas rectifier 42 may be disposed between the manifold 11 and the lowermost heat-insulating ring.

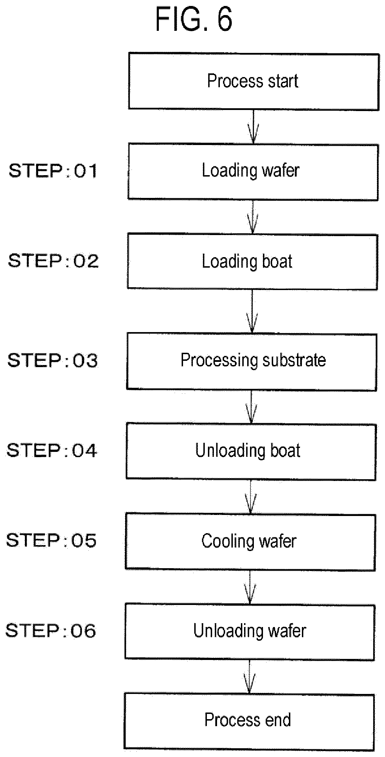

Next, referring to a flow diagram of FIG. 6, substrate processing using the above-described substrate processing apparatus 1 will be described. Here, an example will be described in which an argon (Ar) gas is supplied as the process gas into the process chamber 8 and an annealing process is performed to remove oxygen on the wafer 4. In the present disclosure, the processing temperature means the temperature of the wafer 4 or the temperature of the process chamber 8, and the processing pressure means the internal pressure of the process chamber 8. In the following description, the operation of each part constituting the substrate processing apparatus 1 is controlled by the controller 36.

The description will begin with a state in which the seal cap 34 is lowered by the lifting mechanism (not shown), the boat 3 is removed (i.e., unloaded) from the reaction tube 7, and there are no wafers 4 in the boat 3.

### (Wafer Charging and Boat Loading)

When a FOUP containing the wafers 4 is inserted into the substrate processing apparatus 1, the wafers 4 are transferred to the boat 3 by a transfer machine (not shown) (STEP: 01). When a plurality of wafers 4 are loaded into the boat 3, i.e., the wafers are charged in the boat 3, the seal cap 34 is raised by the lifting mechanism (not shown), the boat 3 is carried inside the induction target 6 in the process chamber 8, i.e., the boat is loaded inside the induction target 6, and the lower opening of the reaction tube 7 is closed (sealed) airtight by the seal cap 34 (STEP: 02).

### (Pressure Adjustment and Temperature Adjustment)

The process chamber 8 is vacuum-exhausted, i.e., decompression-exhausted, by the vacuum pump 33. The internal atmosphere of the process chamber 8 flows linearly or substantially linearly through the exhaust pipe 29 and is exhausted through the vacuum pump 33. Once the internal pressure of the process chamber 8 is vacuum-exhausted, an Ar gas is supplied into the process chamber 8. The Ar gas is controlled to a predetermined flow rate in the gas supply unit 24 and is supplied into the process chamber 8 from the tip of the first gas nozzle 22 through the first gas supply pipe 23 and the first gas nozzle 22. In addition, in parallel with the supply of the Ar gas, that is, with the seal cap 34 closing the opening of the manifold 11, the gas supply unit 24 supplies a purge gas, which is controlled to a desired flow rate, from the second gas supply port 26 through the second gas supply pipe 25 to between the reaction tube 7 and the heat insulator 14. After being ejected upward, the purge gas diffuses in the circumferential direction along the ceiling, descends along the circumferential surface, and is exhausted to the outside of the process chamber 8 through the second exhaust port 28 and the exhaust pipe 29. The internal pressure of the process chamber 8 is measured by the pressure sensor 31, and, the APC valve 32 is feedback-controlled based on the measured pressure information to adjust the internal pressure to a predetermined pressure (degree of vacuum).

In addition, in parallel with the supply of the purge gas from the second gas supply port 26, a purge gas is supplied from the purge gas supplier 41. The purge gas is sprayed sequentially along a flow path formed by the gas rectifier 42 onto the upper surfaces (the inner surface of the process chamber 8) of the view ports 16a to 16d (i.e., the optical window 51 of each view port 16), and then is exhausted to the outside of the process chamber 8 through the second exhaust port 28 and the exhaust pipe 29. Contamination and temperature rise of the optical windows 51 of the view ports 16a to 16d are prevented by the supply of the purge gas from the purge gas supplier 41.

In order to bring the wafers 4 in the process chamber 8 to a predetermined temperature, predetermined AC power is supplied from the AC power source 13 to the induction coil 12 to flow an induced current through the induction target 6 to raise the temperature of the induction target 6, so that the induction target 6 heats the wafers 4 from the surroundings. By heating the wafers 4 by the induction heating, the wafers 4 can be heated efficiently. At this time, a degree of current flow to the induction coil 12 is feedback-controlled based on the temperature information detected by the radiation thermometer 18 so that the entire wafers 4 loaded in the boat 3 have a predetermined temperature distribution. In addition, the boat rotation mechanism 35 starts rotating the boat 3 and the wafers 4.

### (Substrate Processing)

The wafers 4 are heated at a predetermined temperature for a predetermined time in an Ar atmosphere. This activates ion-implanted impurities or removes oxygen from the surface, thereby producing annealed wafers (STEP: 03).

### (Boat Unloading and Wafer Discharging)

After producing the annealed wafers, the current flow to the induction coil 12 is cut off, and the wafers 4 are cooled until their temperature drops to a predetermined temperature. After the wafers 4 are cooled, the APC valve 32 is closed, and the internal pressure of the process chamber 8 is returned to the atmospheric pressure. After that, the seal cap 34 is lowered by the lifting mechanism (not shown), and the boat 3 is carried out of the reaction tube 7, i.e., the boat is unloaded (STEP: 04).

After the boat 3 is taken out, i.e., in a state where the seal cap 34 does not close the opening of the process chamber 8, a cooling process is performed for the wafers 4 and the boat heat-insulator 5 (STEP: 05).

When the wafers 4 and the boat heat-insulator 5 are cooled to a predetermined temperature, the processed wafers 4 loaded into the boat 3 are stored in the FOUP by the transfer machine (not shown), and the FOUP is unloaded from the substrate processing apparatus 1 (STEP: 06), completing the substrate processing.

The process conditions for Ar-annealing the wafers 4 are exemplified as follows:
Processing temperature (wafer temperature): 1500 degrees C to 1900 degrees C
Processing pressure (process chamber internal pressure): 1Pa to normal pressure
Ar gas: 1sccm to 5SLM
N₂ gas: 1 sccm to 5SLM
By setting each process condition to a value within the respective range, a film forming process can proceed appropriately. Note that the notation of a numerical range such as "1500 degrees C to 1900 degrees C" mentioned above means that the lower limit and the upper limit are included in the range. For example, "1500 degrees C to 1900 degrees C" means "1500 degrees C or more and 1900 degrees C or less". The same applies to other numerical ranges.

According to this embodiment, one or more of the following effects can be obtained.

In this embodiment, the partition 42b is provided in an arc shape along the arrangement of the view ports 16a to 16d (the optical windows 51), and the purge gas ejected from the purge gas supplier 41 is guided to the gas rectifier 42 and is sprayed sequentially to the view ports 16a to 16d. In addition, the partition 42b extends from the rear of the purge gas supplier 41 beyond the view port 16 that is the furthest from the purge gas supplier 41, so that the purge gas can reach the view port 16 spaced apart from the purge gas supplier 41 without being scattered.

Therefore, the flow rate of the purge gas can be reduced, foreign matter such as particles that have deposited or are about to deposit on the view port 16 can be blown away to suppress contamination, and the view port 16 can be cooled to suppress a temperature rise, enabling stable temperature measurement with high reproducibility by the radiation thermometer 18 and reducing the frequency of furnace maintenance of the reaction tube 7.

In addition, by supplying the purge gas, a region with a high purge gas concentration, i.e., a low depositional gas concentration, can be formed locally around the view port 16, so that a concentration gradient that prevents the depositional gas from reaching the view port 16 can be formed and maintained.

In addition, in this embodiment, the optical window 51 of the view port 16 is provided so as to be exposed above the upper surface of the manifold 11 in the reaction tube 7. That is, the view port 16 is disposed so that the optical window 51 faces upward, but the partition 42b, etc. of this embodiment can be applied to, for example, a case where the view port 16 is disposed so that the optical window 51 faces sideways. In addition, in this embodiment, the notch 53 is formed on the edge on the outer periphery side of the heat-insulating ring 44, but it may be provided on the inner periphery side. A position where the notch 53 is formed is appropriately selected depending on the position where the view port 16 is provided.

An example where a film is formed using a batch-type substrate processing apparatus that processes a plurality of substrates at a time has been described in the above-described embodiment. The present disclosure is not limited to the above-described embodiment, but can also be suitably applied, for example, to case where a film is formed using a single-wafer type substrate processing apparatus that processes a single substrate or several substrates at a time. In addition, an example in which a film is formed using a substrate processing apparatus provided with a hot-wall-type process furnace has been described in the above-described embodiment. The present disclosure is not limited to the above-described embodiment, but can also be suitably applied to a case where a film is formed using a substrate processing apparatus provided with a cold-wall-type process furnace.

According to the present disclosure in some embodiments, it is possible to provide a technique capable of stable temperature measurements.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus (1) comprising:
at least one port (16a, 16b, 16c, 16d) provided in a process container (7) in which a substrate (4) is accommodated and heat-treated, the at least one port (16a, 16b, 16c, 16d) providing an optical path that penetrates an interior of the process container (7) and an exterior of the process container (7);
an optical window (51) that is mounted to the at least one port (16a, 16b, 16c, 16d) and transmits light while maintaining the port (16a, 16b, 16c, 16d) airtight;
a purge gas supplier (41) that is disposed inside the process container (7) and provides a purge gas to an inner surface of the optical window (51); and
a partition (42b) that guides the purge gas from the purge gas supplier (41) to the optical window (51).

2. The substrate processing apparatus (1) of Claim 1, wherein the partition (42b) is provided in substantially parallel to the optical path (51).

3. The substrate processing apparatus (1) of any one of Claims 1 and 2, wherein the at least one port (16a, 16b, 16c, 16d) and the purge gas supplier (41) are disposed on an inner periphery side of the process container (7) along an opening of the process container (7) in a circular shape, and the partition (42b) is formed in an arc shape on the inner periphery side of the at least one port (16a, 16b, 16c, 16d) and the purge gas supplier (41).

4. The substrate processing apparatus (1) of any one of Claims 1 to 3, wherein the at least one port (16a, 16b, 16c, 16d) includes a plurality of ports (16a, 16b, 16c, 16d), and
wherein the plurality of ports (16a, 16b, 16c, 16d) are arranged along an imaginary circle concentric with the tube axis of the process container (7), and the partition (42b) extends along the arrangement of the plurality of ports (16a, 16b, 16c, 16d).

5. The substrate processing apparatus (1) of any one of Claims 1 to 4, further comprising: a cylindrical heat-generator (6) that is disposed inside the process container (7) and is induction-heated,
wherein the at least one port (16a, 16b, 16c, 16d) is provided along an inner periphery of the heat-generator (6) so that the optical path extends inside the heat-generator (6) in a longitudinal direction of the process container (7).

6. The substrate processing apparatus (1) of any one of Claims 1 to 5, wherein the at least one port (16a, 16b, 16c, 16d) is formed in a cylindrical shape and has an end that opens upward on a surface (1 1a) of a manifold (11), the surface (1 1a) of the manifold (11) being perpendicular to the tube axis of the process container (7) on an opening side of the process container (7).

7. The substrate processing apparatus (1) of any one of Claims 1 to 6, further comprising: a cylindrical portion (48) that is formed in a cylindrical shape, is mounted inside the at least one port (16a, 16b, 16c, 16d), and fixes the optical window (51) airtight and holds the optical window (51) inside the cylindrical portion (48),
wherein the at least one port (16a, 16b, 16c, 16d) includes a seal (49) that seals airtight between the at least one port (16a, 16b, 16c, 16d) and an outer periphery of the cylindrical portion (48).

8. The substrate processing apparatus (1) of any one of Claims 1 to 7, further comprising: a gas rectifier (42) including the partition (42b) and a plate (42a) that is arranged inside the process container (7) so as to partially cover the upper side of the at least one port (16a, 16b, 16c, 16d),
wherein the plate (42a) and the partition (42b) are connected at substantially a right angle.

9. The substrate processing apparatus (1) of Claim 8, wherein the plate (42a) is formed in an open ring shape, and the partition (42b) is connected to an end of an inner periphery or an outer periphery of the plate (42a).

10. The substrate processing apparatus (1) of Claim 9, further comprising: a heat-insulating assembly (43) that includes a plurality of heat-insulating rings (44) held in multiple stages and the gas rectifier (42), and is installed in a vicinity of an opening of the process container (7).

11. The substrate processing apparatus (1) of Claim 5, further comprising: a heat-insulating ring (44) that is arranged in a vicinity of an opening of the process container (7),
wherein the heat-insulating ring (44) covers an upper side of a region surrounded by the partition (42b) and the heat-generator (6) and guides the purge gas from the purge gas supplier (41) to the optical window (51).

12. The substrate processing apparatus (1) of Claim 6, wherein the optical window (51) is disposed in the at least one port (16a, 16b, 16c, 16d) on substantially the same plane as an inner surface (11a) of the manifold (11).

13. A method of processing a substrate (4), comprising:
accommodating a substrate (4) in a process container (7) including a port (16a, 16b, 16c, 16d) that is provided in the process container (7) in which the substrate (4) is accommodated and heat-treated, the port (16a, 16b, 16c, 16d) providing an optical path that penetrates an interior of the process container (7) and an exterior of the process container (7);
transmitting light through an optical window (51) mounted to the port (16a, 16b, 16c, 16d) while maintaining the airtightness of the port (16a, 16b, 16c, 16d);
guiding a purge gas from a purge gas supplier (41) disposed inside the process container (7) to the optical window (51); and
guiding the purge gas from the purge gas supplier (41) to the optical window (51) by a partition (42b).

14. A method of manufacturing a semiconductor device, comprising the method of claim 13.

15. A gas rectifier (42) comprising:
a plate (42a) that is arranged inside a process container (7) in which a substrate (4) is accommodated and heat-treated, to face a port (16a, 16b, 16c, 16d) that provides an optical path penetrating an interior of the process container (7) and an exterior of the process container (7), and to partially cover the port (16a, 16b, 16c, 16d); and
a partition (42b) that is provided in substantially parallel to the optical path,
wherein the plate (42a) and the partition (42b) are provided between a purge gas supplier (41) disposed adjacent to the port (16a, 16b, 16c, 16d) in the process container (47) and an optical window (51) mounted to the port (16a, 16b, 16c, 16d).
